(19) **Europäisches Patentamt / European Patent Office / Office européen des brevets**

(11) **EP 4 498 103 A1**

(12) **EUROPEAN PATENT APPLICATION**
published in accordance with Art. 153(4) EPC

(43) Date of publication:
29.01.2025 Bulletin 2025/05

(21) Application number: 22933780.3

(22) Date of filing: 25.11.2022

(51) International Patent Classification (IPC):
*G01R 31/367* (2019.01)   *G01R 31/392* (2019.01)
*G01R 31/382* (2019.01)

(52) Cooperative Patent Classification (CPC):
G01R 31/367; G01R 31/382; G01R 31/392;
Y02E 60/10

(86) International application number:
PCT/KR2022/018849

(87) International publication number:
WO 2023/182611 (28.09.2023 Gazette 2023/39)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 21.03.2022 KR 20220034948

(71) Applicant: LG Energy Solution, Ltd.
Seoul 07335 (KR)

(72) Inventors:
• SHIN, Jae Wook
Daejeon 34122 (KR)
• CHOI, Sung Wook
Daejeon 34122 (KR)
• YOO, Ji Won
Daejeon 34122 (KR)

(74) Representative: Goddar, Heinz J.
Boehmert & Boehmert
Anwaltspartnerschaft mbB
Pettenkoferstrasse 22
80336 München (DE)

(54) **BATTERY MANAGEMENT DEVICE AND METHOD**

(57) A battery management apparatus according to an embodiment of the present disclosure includes a data obtaining unit for obtaining battery information including at least one of voltage and current of a battery and a controller for estimating a state of health (SOH) of the battery based on the battery information, calculating an SOH score for the battery based on a reference value corresponding to the SOH and the SOH in a plurality of reference profiles, predicting a plurality of SOH of the battery during a target period, calculating a remaining useful life (RUL) score for the battery based on the plurality of SOH, and determining a safety score of the battery according to a safety class of the battery based on the battery information.

100

BATTERY MANAGEMENT APPARATUS

DATA OBTAINING UNIT ~110

CONTROLLER ~120

STORAGE UNIT ~130

FIG.1

EP 4 498 103 A1

**Description**

**[TECHNICAL FIELD]**

CROSS-REFERENCE TO RELATED APPLICATION

This application claims priority to and the benefit of Korean Patent Application No. 10-2022-0034948 filed in the Korean Intellectual Property Office on March 21, 2022, the entire contents of which are incorporated herein by reference.

TECHNICAL FIELD

The present disclosure relates to a battery management apparatus and method, and more particularly, to a battery management apparatus and method capable of evaluating a life of a battery.

**[BACKGROUND ART]**

Recently, as the demand for portable electronic products such as laptop computers, video cameras, and mobile phones has increased rapidly, and development of electric vehicles, batteries for energy storage, robots, satellites, etc., has hit its stride, research on high-performance batteries that are repeatedly chargeable and dischargeable is being actively conducted.

Current commercially available batteries include nickel cadmium batteries, nickel hydride batteries, nickel zinc batteries, lithium batteries, and so forth, among which the lithium batteries are in the limelight due to their advantages of free charge and discharge due to little memory effect, very low self-discharge rate, and high energy density, compared to nickel-based batteries.

In general, as a battery deteriorates with use, it is necessary to accurately diagnose the state of the battery in order to increase the life expectancy of the battery. Conventionally, by estimating a state of charge (SOH), a remaining useful life (RUL), etc. of a battery in various ways, a performance test for the current life and the remaining life of the battery has been conducted.

However, these terms are not familiar to general users, resulting in a concern that the general users may not be able to accurately understand meanings of the SOH, the RUL, etc. Therefore, it is necessary to develop a technique for helping the general users with intuitive understanding by comprehensively evaluating the life of the battery from various aspects.

**[DISCLOSURE]**

**[TECHNICAL PROBLEM]**

The present disclosure aims to provide a battery management apparatus and method capable of evaluating and scoring a life of a battery.

Other objects and advantages of the present disclosure may be understood by the following description, and will be more clearly understood by embodiments of the present disclosure. In addition, it would be easily understood that the object and advantages of the disclosure may be implemented by means provided in the claims and a combination thereof.

**[TECHNICAL SOLUTION]**

A battery management apparatus according to an aspect of the present disclosure includes a data obtaining unit configured to obtain battery information including at least one of voltage and current of a battery and a controller configured to estimate a state of health (SOH) of the battery based on the battery information, calculate an SOH score for the battery based on a reference value corresponding to the SOH and the SOH in a plurality of reference profiles, predict a plurality of SOH of the battery during a target period, calculate a remaining useful life (RUL) score for the battery based on the plurality of SOH, and determine a safety score of the battery according to a safety class of the battery based on the battery information.

The plurality of reference profiles may be configured to include a first reference profile indicating a maximum SOH per unit time for the battery and a second reference profile indicating a minimum SOH per unit time for the battery.

The controller may be further configured to determine a first reference value corresponding to the SOH in the first reference profile, determine a second reference value corresponding to the SOH in the second reference profile, and calculate the SOH score based on a rate of the SOH with respect to the first reference value and the second reference value.

The controller may be further configured to determine a SOH reference section for the first reference value and the second reference value, calculate a rate of the SOH with respect to the SOH reference section, and score the calculated rate to calculate the SOH score.

The controller may be further configured to determine a plurality of first reference values during the target period in the first reference profile, determine a plurality of second reference values during the target period in the second reference profile, and calculate the RUL score based on a rate of the plurality of SOH with respect to the plurality of first reference values and the plurality of second reference values.

The controller may be further configured to determine an RUL reference section for a sum of the plurality of first reference values and a sum of the plurality of second reference values, calculate a rate of a sum of the plurality of SOH with respect to the RUL reference section, and score the calculated rate to calculate the RUL score.

The plurality of reference profiles may be configured to include a third reference profile indicating an average SOH per unit time for the battery.

The controller may be further configured to determine a target time point corresponding to a preset threshold value in the third reference profile, and set a period from a current time point at which the SOH is estimated to the target time point as the target period.

The target period may be set as a period from the current time point at which the SOH is estimated, to an expiration time point of a preset warranty period for the battery.

The controller may be further configured to calculate the safety score corresponding to the safety class based on a preset safety class table.

The controller may be further configured to determine an abnormal behavior of the battery information, calculate a similarity between the determined abnormal behavior and a preset abnormal profile, and determine the safety class based on the calculated similarity.

The controller may be further configured to determine a battery life score by applying a weight value preset to correspond to each of the SOH score, the RUL score, and the safety score and summing an application result.

A battery system according to another aspect of the present disclosure includes the battery management apparatus according to the aspect of the present disclosure.

A battery pack according to another aspect of the present disclosure includes the battery management apparatus according to the aspect of the present disclosure.

A battery management method according to another aspect of the present disclosure includes a battery information obtaining operation of obtaining battery information including at least one of voltage and current of a battery, a state of health (SOH) score calculating operation of estimating an SOH of the battery based on the battery information and calculating an SOH score for the battery based on a reference value corresponding to the SOH and the SOH in a plurality of reference profiles, a remaining useful life (RUL) score calculating operation of predicting a plurality of SOH of the battery during a target period and calculating an RUL score for the battery based on the plurality of SOH, and a safety score calculating operation of calculating a safety score of the battery according to a safety class of the battery based on the battery information

**[ADVANTAGEOUS EFFECTS]**

According to an aspect of the present disclosure, the battery management apparatus may evaluate performing of the battery from various aspects by calculating each of the SOH score, the RUL score, and the safety score for the battery.

According to an aspect of the present disclosure, the battery management apparatus may not only provide detailed scores such as the SOH score, the RUL score, the safety score, etc., for the battery, but also provide the battery life score, calculated by combining the detailed scores. Thus, users may identify detailed scores for the battery management apparatus and also the battery life score which is a combined score. In particular, when a user fails to accurately recognize what the detailed scores mean, the user may identify the battery life score, thereby intuitively identifying a performance evaluation result for the battery the user uses.

Effects of the present disclosure are not limited to the aforementioned effects, and other unmentioned effects would be apparent to one of ordinary skill in the art from the claims.

**[DESCRIPTION OF DRAWINGS]**

The following drawings attached to the present specification serve to further understand the technical spirit of the present disclosure together with the detailed description of the disclosure to be provided later, and thus the present disclosure should not be construed as being limited only to the matters described in the drawings.

FIG. 1 is a diagram schematically showing a battery management apparatus according to an embodiment of the present disclosure.

FIG. 2 is a view schematically showing an example of a plurality of profiles considered for a battery management apparatus according to an embodiment of the present disclosure to calculate a state of health (SOH) score.

FIG. 3 is a view schematically showing an example where a SOH score is calculated according to an embodiment of the present disclosure.

FIG. 4 is a view schematically showing an example of a plurality of profiles considered for a battery management apparatus according to an embodiment of the present disclosure to calculate a remaining useful life (RUL) score.

FIG. 5 is a view schematically showing an example where an RUL score is calculated according to an embodiment of the present disclosure.

FIG. 6 is a view schematically showing another example of a plurality of profiles considered for a battery management apparatus according to an embodiment of the present disclosure to calculate an RUL score.

FIG. 7 is a view schematically showing an example of a preset safety class table according to an embodiment of the present disclosure.

FIG. 8 is a diagram schematically showing an exemplary configuration of a battery system according to another embodiment of the present disclosure.

FIG. 9 is a view schematically showing an output example of a life score provided to a user, according to an embodiment of the present disclosure.

FIG. 10 is a diagram schematically showing an exemplary configuration of a battery pack according to another embodiment of the present disclosure.

FIGS. 11 and 12 are diagrams schematically showing a battery management method according to another embodiment of the present disclosure.

**[MODE FOR INVENTION]**

Further, terms or words used in the description and claims below should not be interpreted as only general or dictionary meanings, but interpreted as meanings and concepts satisfying the technical spirit of the present invention based on a principle in that the inventor can appropriately define his/her invention with a concept of the terms in order to describe the invention in the best method.

Therefore, since the embodiments described in the present specification and the configurations shown in the drawings are only one of the most preferred embodiments of the present invention and do not represent all of the technical spirit of the present disclosure, it should be understood that there may be various equivalents and modifications capable of replacing them at the time of filing of the present disclosure.

When the present disclosure is described, a detailed description of related well-known configurations or techniques will be omitted if it obscures the subject matter of the present invention.

Terms including ordinal numbers, such as first, second, etc., are used for the purpose of distinguishing one of various components from the others, and are not used to limit the components by such terms.

Throughout the entirety of the specification of the present disclosure, when it is assumed that a certain part includes a certain component, the term 'including' means that a corresponding component may further include other components unless specially described to the contrary.

In the description of the embodiments of the disclosure, when a part is "connected" to another part, the part is not only "directly connected" to another part but also "indirectly connected" to another part with another device intervening in them.

Generally, a battery cell may include a negative terminal and a positive terminal and mean one independent cell that is physically separable. For example, a lithium ion battery or a lithium polymer battery may be regarded as a battery cell. In addition, a battery module may include a plurality of battery cells connected in series and/or in parallel. A battery pack may include a plurality of battery modules or a plurality of battery cells connected in series and/or in parallel. A battery described below may be a battery cell, a battery module, or a battery pack.

Hereinafter, a preferred embodiment of the present disclosure will be described in detail with reference to the accompanying drawings.

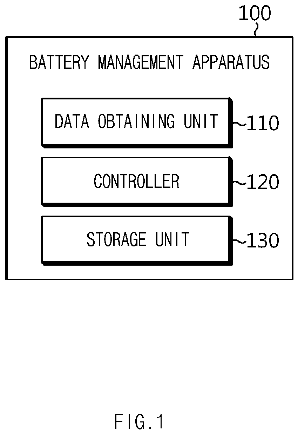

FIG. 1 is a diagram schematically showing a battery management apparatus 100 according to an embodiment of the present disclosure.

Referring to FIG. 1, a battery management apparatus 100 may include a data obtaining unit 110 and a controller 120.

The data obtaining unit 110 may be configured to obtain battery information of at least one of voltage and current of a battery.

For example, the data obtaining unit 110 may receive battery information from an external source through wired and/or wireless communication. Herein, the battery information may include at least one of voltage and current of the battery, obtained during a process of charging and discharging the battery.

Preferably, to minimize omission or redundancy of the obtained battery information, the data obtaining unit 110 may periodically receive the battery information to obtain the battery information. For example, the data obtaining unit 110 may obtain the battery information every 24 hours.

The controller 120 may be configured to estimate a state of health (SOH) of the battery based on the battery information.

Herein, the SOH may be a performance index indicating a health state (an aging state or a deteriorating state) of the battery. Generally, the SOH may be estimated by comparing a state of a beginning-of-life (BoL) battery with a current state of the battery and may be expressed as 0 to 1 or 0 % to 100 %.

For example, the controller 120 may determine the current state of the battery with respect to a capacity, an internal resistance, a coulombic efficiency (CE), a diffusion coefficient, an active material amount, etc., based on the battery information. The controller 120 may estimate the SOH of the battery by comparing the determined current state of the battery with an initial state preset for the BOL battery.

The controller 120 may be configured to calculate a SOH score for the battery based on a reference value corresponding to the SOH and the SOH in a plurality of reference profiles.

Herein, the SOH score may be a score obtained by evaluating the SOH of the battery, and may be expressed as 0 to 100 points. More specifically, a maximum SOH and a minimum SOH for the battery may be set based on various experiment data for the battery. A rate of the current SOH with respect to the maximum SOH and the minimum SOH may be calculated in terms of a SOH score.

The plurality of reference profiles may be configured to include a first reference profile RP1 indicating the maximum SOH per unit time for the battery and a second reference profile RP2 indicating the minimum SOH per unit time for the battery. The first reference profile RP1 may be a SOH profile P representing the highest performance of the battery among various experiment data obtained in advance, and the second reference profile RP2 may be a SOH profile P representing the lowest performance of the battery among the various experiment data obtained in advance. Preferably, charge/discharge experiments are performed on the current battery and the same type of a battery under various experiment conditions, and experiment data for each experiment condition may be obtained in advance.

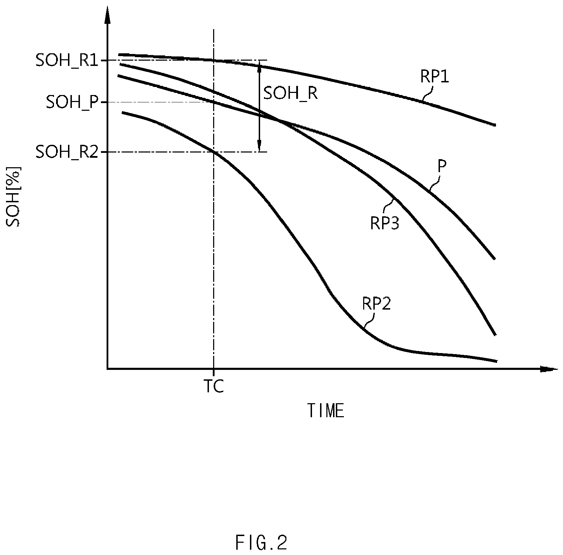

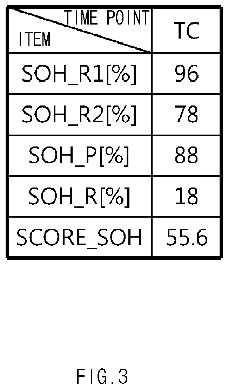

FIG. 2 is a view schematically showing an example of a plurality of profiles considered for the battery management apparatus 100 according to an embodiment of the present disclosure to calculate a SOH score SCORE_SOH. FIG. 3 is a view schematically showing an example where the SOH score SCORE_SOH is calculated according to an embodiment of the present disclosure.

In the embodiment of FIG. 2, the first reference profile RP1 may indicate the maximum SOH per unit time for the battery, and the second reference profile RP2 may indicate the minimum SOH per unit time for the battery. A third reference profile RP3 may indicate a reference SOH per unit time for the battery. The SOH profile P may indicate a SOH per unit time, estimated for the current battery.

The controller 120 may determine a first reference value SOH_R1 corresponding to the estimated SOH in the first reference profile RP1, and a second reference value SOH_R2 corresponding to the estimated SOH in the second reference profile RP2. The controller 120 may be configured to calculate the SOH score SCORE_SOH based on a rate of a SOH with respect to the first reference value SOH_R1 and the second reference value SOH R2.

For example, the controller 120 may normalize the second reference value SOH_R2 to 0 point and normalize the first reference value SOH_R1 to 100 points. The controller 120 may calculate the SOH score SCORE_SOH by converting the estimated SOH into any one of 0 point to 100 points.

For example, in the embodiment of FIG. 3, the first reference value SOH_R1 may be 96 %, and the second reference value SOH_R2 may be 78 %. The current SOH of the battery may be estimated as 88 %. In this case, a SOH reference section SOH_R between the first reference value SOH_R1 and the second reference value SOH_R2 may be 78 % to 96 %, and a size of the SOH reference section SOH_R may be 18 %. Thus, the controller 120 may calculate the SOH score SCORE_SOH as 55.6 points.

That is, the controller 120 may evaluate performance of the battery in terms of a SOH by calculating the SOH score SCORE_SOH of the battery based on the maximum SOH and the minimum SOH of the battery with respect to various experiment data obtained in advance.

The controller 120 may be configured to predict a plurality of SOH of the battery during a target period TR.

More specifically, the controller 120 may be configured to predict a SOH for the future time point after the current time point TC based on the SOH of the battery estimated until the current time point TC. Herein, the target period TR may be a period in which SOH values for calculating an RUL score SCORE_RUL are selected, and may be a preset period. Details for the target period TR will be described later.

For example, in the embodiment of FIG. 2, the SOH values for the SOH profile P after the current time point TC may be values predicted based on SOH of the battery estimated from the past to the present. That is, the controller 120 may predict the future SOH based on the SOH of the battery estimated from the past to the current. The controller 120 may generate the SOH profile P to include the SOH estimated in the past, the SOH estimated at the current time point TC, and the SOH predicted for the future time point.

The controller 120 may be configured to calculate a remaining useful life (RUL) score for the battery based on a plurality of reference values corresponding to the plurality of SOH and the plurality of SOH in the plurality of reference profiles.

Herein, the RUL may be an indicator of the remaining life of the battery.

More specifically, the controller 120 may determine the plurality of SOH and the plurality of reference values corresponding thereto at every predetermined intervals in the target period TR. The controller 120 may also calculate an RUL score SCORE_RUL for the battery based on a rate of the plurality of SOH with respect to the plurality of reference values.

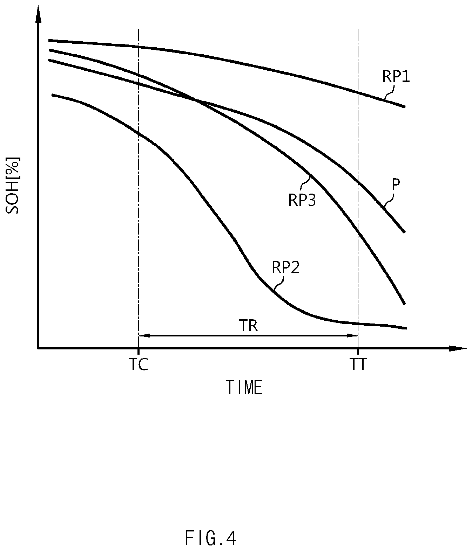

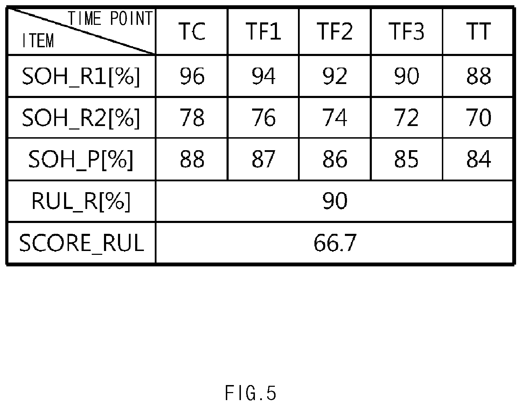

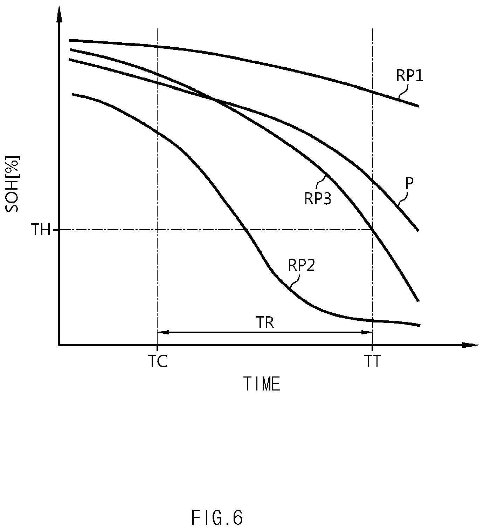

FIG. 4 is a view schematically showing an example of a plurality of profiles considered for the battery management apparatus 100 according to an embodiment of the present disclosure to calculate the RUL score SCORE_RUL. FIG. 5 is a view schematically showing an example where the RUL score SCORE_RUL is calculated according to an embodiment of the present disclosure. FIG. 6 is a view schematically showing another example of a plurality of profiles considered for the battery management apparatus 100 according to an embodiment of the present disclosure to calculate the RUL score SCORE RUL.

In the embodiment of FIG. 4, the target period TR is assumed to be from the current time point TC to a target time point TT. The controller 120 may determine a plurality of first reference values SOH_R1, a plurality of second reference values SOH R2, and a plurality of SOH at predetermined intervals in the target period TR. Herein, it should be noted that the first reference value SOH_R1, the second reference value SOH_R2, and the SOH may regard the same time point.

More specifically, unlike the SOH score SCORE_SOH, the RUL score SCORE_RUL may not be calculated for each time point, and may be calculated by collecting SOH changes in the target period TR. The controller 120 may determine the plurality of first reference values SOH_R1 in the first reference profile RP1, and the plurality of second reference values SOH_R2 in the second reference profile RP2. The controller 120 may calculate the RUL score SCORE_RUL by scoring a rate with respect to a sum of the plurality of SOH in an RUL reference section RUL _R corresponding to the plurality of first reference values SOH_R1 and the plurality of second reference values SOH R2.

For example, the controller 120 may normalize a sum of the plurality of first reference values SOH_R1 to 100 points and normalize a sum of the plurality of second reference values SOH_R2 to 0 point. The controller 120 may calculate the RUL score SCORE_RUL by converting the sum of the plurality of SOH into any one of 0 point to 100 points.

For example, in the embodiment of FIG. 5, it is assumed that the RUL score SCORE_RUL is calculated based on the current time point TC, a first future time point TF 1, a second future time point TF2, a third future time point TF3, and the target time point TT.

Five first reference values SOH_R1 selected in the first reference profile RP1 may be 96 %, 94 %, 92 %, 90 %, and 88 %, respectively. Five second reference values SOH_R2 selected in the second reference profile RP2 may be 78%, 76%, 74%, 72 %, and 70 %, respectively. Five SOH selected in the SOH profile P may be 88%, 87%, 86%, 85%, and 84 %, respectively. The RUL reference section RUL_R for the target period may be from 370 % to 460 %, and the size of the RUL reference section RUL_R may be 90 %. Thus, the controller 120 may calculate the RUL score SCORE_RUL as 66.7 points.

That is, the controller 120 may evaluate the performance of the battery in terms of a RUL by calculating the RUL score SCORE _RUL based on the plurality of first reference values SOH_R1 and the plurality of second reference values SOH_R2 during the target period TR.

The controller 120 may be configured to determine a safety score SCORE_SAFETY of the battery according to a safety class of the battery based on the battery information.

Herein, the safety class may be calculated based on the battery information and may be an indicator indicating a safety level of the battery. For example, the controller 120 may determine the safety class of the battery based on voltage and/or current in the battery information.

More specifically, the controller 120 may determine the safety class of the battery based on a similarity between the battery information and a plurality of preset abnormality data.

For example, the controller 120 may calculate the similarity between the battery information and the plurality of abnormality data without checking an abnormal behavior of the battery information. This is because when any abnormal behavior does not occur in the battery information, a similarity to abnormality data may be calculated as being low. The controller 120 may determine the safety class of the battery based on the similarity to the plurality of abnormality data.

In another example, the controller 120 may calculate the similarity between the battery information and the plurality of preset abnormality data when the abnormal behavior is identified from the battery information. This is intended to prevent a system resource from being unnecessarily wasted, by calculating the similarity between the battery information and the plurality of abnormality data when the abnormal behavior is identified. The controller 120 may determine the safety class of the battery based on the similarity calculated for the plurality of abnormality data.

The controller 120 may be configured to calculate the safety score SCORE_SAFETY corresponding to the safety class based on a preset safety class table.

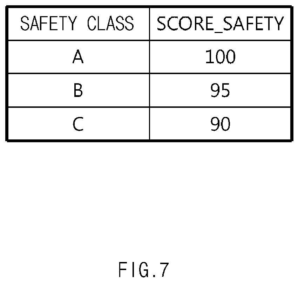

FIG. 7 is a view schematically showing an example of a preset safety class table according to an embodiment of the present disclosure.

For example, in the embodiment of FIG. 7, the safety class of the battery may be classified into a class A, a class B, and a class C. The safety score SCORE_SAFETY may be set to 100 points, 95 points, and 90 points respectively for the class A, the class B, and the class C. The safety class table according to FIG. 7 is merely an embodiment, and it should be noted that the number of classified safety classes and the safety score SCORE_SAFETY set for each safety class may change.

The battery management apparatus 100 according to an embodiment of the present disclosure may evaluate performing of the battery from various aspects by calculating each of the SOH score SCORE_SOH, the RUL score SCORE_RUL, and the safety score SCORE_SAFETY for the battery.

As the battery management apparatus 100 provides a normalized point (normalized between 0 points and 100 points) as each performance evaluation result, a user may intuitively identify the current performance of the battery.

Meanwhile, the controller 120 included in the battery management apparatus 100 may selectively include a processor, an application-specific integrated circuit (ASIC), other chipsets, a logic circuit, a register, a communication modem, a data processing device, etc., known in this field to execute various control logics performed herein. Thus, when the control logic is implemented as software, the controller 120 may be implemented as a group of program modules. In this case, the program module may be stored in a memory and may be executed by the controller 120. The memory may be inside or outside the controller 120 and may be connected to the controller 120 by well-known various means.

Moreover, the battery management apparatus 100 may further include a storage unit 130. The storage unit 130 may store data or a program required for each component of the battery management apparatus 100 to perform an operation and a function of each component or data, etc., generated in a process of performing the operation and the function. The storage unit 130 may not be specially limited to a specific type as long as it is a well-known information storage means known to record, erase, update, and read data. As an example, the information storage means may include RAM, flash memory, ROM, EEPROM, register, etc. In addition, the storage unit 130 may store program codes where processes executable by the controller 120 are defined.

The battery information obtained by the data obtaining unit 110 may be stored in the storage unit 130. The controller 120 may access the storage unit 130 to obtain the battery information.

Hereinbelow, a detailed description will be made of an embodiment where the controller 120 calculates the SOH score SCORE_SOH.

The controller 120 may be configured to determine the SOH reference section SOH_R for the first reference value SOH_R1 and the second reference value SOH_R2.

More specifically, the first reference value SOH_R1 may be a SOH value determined in the first reference profile RP1 indicating the maximum SOH for the battery, and the second reference value SOH_R2 may be a SOH value determined in the second reference profile RP2 indicating the minimum SOH for the battery. That is, the first reference value SOH_R1 may be equal to or greater than the second reference value SOH_R2. Thus, the controller 120 may determine a SOH section from the second reference value SOH_R2 to the first reference value SOH_R1 as the SOH reference section SOH_R. That is, a lower limit of the SOH reference section SOH_R may be the second reference value SOH_R2, and an upper limit of the SOH reference section SOH_R may be the first reference value SOH_R1.

For example, in the embodiment of FIG. 3, the SOH reference section SOH_R may be a section from a SOH of 78 % to 96 %.

The controller 120 may be configured to calculate a rate of a SOH with respect to the SOH reference section SOH_R and score the calculated rate to calculate the SOH score SCORE_SOH. More specifically, the controller 120 may calculate the SOH score SCORE_SOH by using Equation 1 below.

[Equation 1]

$$SCORE\_SOH = \frac{SOH\_P - SOH\_R2}{SOH\_R1 - SOH\_R2} \times 100$$

Herein, SCORE_SOH may indicate a SOH score, SOH_R1 may indicate a first reference value, SOH_R2 may indicate a second reference value, and SOH_P may indicate an estimated SOH value of the battery. 100 may be a constant added to express the SOH score SCORE_SOH as a score between 0 points and 100 points, and may be omitted.

For example, in the embodiment of FIG. 3, the size of the SOH reference section SOH_R may be "18 %" calculated according to an equation of "96 % - 78 %". A difference between the estimated SOH SOH_P and the second reference value SOH_R2 may be "10 %" calculated according to an equation of "88 % - 78 %". Thus, the SOH score SCORE_SOH may be 55.6 calculated according to an equation of "10 % ÷ 18 % × 100".

Hereinbelow, a detailed description will be made of an embodiment where the controller 120 calculates the RUL score SCORE_RUL.

The controller 120 may determine the plurality of first reference values SOH_R1 in the first reference profile RP1 during the target period TR, and the plurality of second reference values SOH_R2 in the second reference profile RP2 during the target period TR. For example, the controller 120 may determine the first reference value SOH_R1 and the second reference value SOH_R2 at predetermined intervals in the target period TR.

For example, in the embodiment of FIG. 5, the controller 120 may determine the first reference value SOH_R1 and the second reference value SOH_R2 at each of the current time point TC, the first future time point TF1, the second future time point TF2, the third future time point TF3, and the target time point TT. The determined first reference value SOH_R1 may be 96 %, 94 %, 92 %, 90 %, and 88 %, and the determined second reference value SOH_R2 may be 78 %, 76 %, 74 %, 72 %, and 70 %.

The controller 120 may be configured to calculate the RUL score SCORE_RUL based on a rate of a plurality of SOH with respect to the plurality of first reference values SOH_R1 and the plurality of second reference values SOH_R2.

For example, in the embodiment of FIG. 5, the controller 120 may estimate a SOH SOH_P of the battery at each of the current time point TC, the first future time point TF1, the second future time point TF2, the third future time point TF3, and the target time point TT. The estimated SOH SOH_P may be 88 %, 87%, 86 %, 85 %, and 84 %.

More specifically, the controller 120 may be configured to determine the RUL reference section RUL_R for a sum of the plurality of first reference value SOH_R1 and a sum of the plurality of second reference values SOH_R2.

For example, in the embodiment of FIG. 5, the sum of the plurality of first reference values SOH_R1 may be 460 %, and the sum of the plurality of second reference values SOH_R2 may be 370 %. The controller 120 may determine a SOH section from the sum of the plurality of second reference values SOH_R2 to the sum of the plurality of first reference values SOH_R1 as the RUL reference section RUL_R. That is, a lower limit of the RUL reference section RUL_R may be the sum of the plurality of second reference values SOH_R2, and an upper limit of the RUL reference section RUL_R may be the sum of the plurality of first reference values SOH_R1.

The controller 120 may be configured to calculate a rate of a sum of the plurality of SOH SOH_P with respect to the RUL reference section RUL_R and score the calculated rate to calculate the RUL score SCORE_RUL. More specifically, the controller 120 may calculate the RUL score SCORE_RUL by using Equation 2 below.

[Equation 2]

$$SCORE\_RUL = \frac{\sum SOH\_P - \sum SOH\_R2}{\sum SOH\_R1 - \sum SOH\_R2} \times 100$$

Herein, SCORE_RUL may indicate an RUL score, $\Sigma$SOH_R1 may indicate a sum of a plurality of first reference values, $\Sigma$SOH_R2 may indicate a sum of a plurality of second reference values, and $\Sigma$SOH_P may indicate a sum of a plurality of SOH. 100 may be a constant added to express the RUL score SCORE_RUL as a score between 0 points and 100 points, and may be omitted.

For example, in the embodiment of FIG. 5, the size of the RUL reference section RUL_R may be "90 %" calculated according to an equation of "460 % - 370 %". A difference between the sum of the plurality of SOH SOH_P and the sum of the plurality of second reference values SOH_R2 may be "60 %" calculated according to an equation of "430 % - 370 %". Thus, the RUL score SCORE_RUL may be 66.7 calculated according to an equation of "60 % ÷ 90 % × 100".

That is, the SOH score SCORE_SOH may be calculated based on the first reference value SOH_R1, the second reference value SOH_R2, and the estimated SOH SOH_P for one time point, but the RUL score SCORE_RUL may be calculated based on the plurality of first reference values SOH_R1, the plurality of second reference values SOH_R2, and the plurality of SOH SOH_P determined in the target period TR. Thus, each of the SOH score SCORE_SOH and the RUL score SCORE_RUL may be evaluated as a performance indicator for the battery.

Meanwhile, the target period TR considered to calculate the RUL score SCORE_RUL may be a preset period. Preferably, the target period TR may be a period to the future target time point TT from the current time point TC.

For example, the target period TR may be set as a period from the current time point TC at which the SOH is estimated, to an expiration time point of a preset warranty period for the battery.

Generally, as batteries deteriorate with use, a battery manufacturer sets a warranty period for guaranteeing performance of the batteries. For example, the warranty period for the battery may be set to 5 years, 10 years, etc. The controller 120 may identify the warranty period set for the battery and set a period from the current time point to the expiration time point of the warranty period as the target period TR.

For example, in the embodiment of FIG. 4, the target time point TT that is the expiration time point of the warranty period may be TT. Thus, the controller 120 may set a period from the current time point TC to the target time point TT as the target period TR. The controller 120 may calculate the RUL score SCORE_RUL based on the plurality of first reference values SOH_R1, the plurality of second reference values SOH_R2, and the plurality of SOH.

In another example, the target period TR may be set to correspond to a preset threshold value TH.

The plurality of reference profiles may be configured to include the third reference profile RP3 indicating an average SOH per unit time for the battery.

The controller 120 may be configured to determine the target time point TT corresponding to the preset threshold value TH from the third reference profile RP3.

Herein, the third reference profile RP3 may be the SOH profile P indicating a SOH of a reference battery. That is, the third reference profile RP3 may mean a SOH profile that may appear when the battery operates under recommended conditions. For example, the third reference profile RP3 may mean a SOH profile that may appear when the reference battery included in an electric vehicle operates under recommended conditions.

The controller 120 may determine the target time point TT corresponding to the preset threshold value TH from the third reference profile RP3. For example, in the embodiment of FIG. 6, the target time point TT corresponding to the preset threshold value TH may be TT.

For example, the threshold value TH may be a guaranteed SOH that is preset for the battery. The guaranteed SOH may be a SOH lower limit that is set to enable maintenance, repair, etc., of the battery, and may be set by a battery manufacturer like the warranty period.

In another example, the threshold value TH may be a SOH corresponding to a predetermined rate of the current SOH. Herein, the predetermined rate may be any one of over 0 % and below 100 %. For example, the threshold value TH may be a SOH corresponding to 80 % of the current estimated SOH.

Last, the controller 120 may be configured to set a period from the current time point TC at which the SOH is estimated to the target time point TT as the target period TR.

For example, in the embodiment of FIG. 6, the controller 120 may set a period from the current time point TC to the target time point TT as the target period TR. The controller 120 may calculate the RUL score SCORE RUL based on the plurality of first reference values SOH_R1, the plurality of second reference values SOH_R2, and the plurality of SOH.

Hereinbelow, a detailed description will be made of an embodiment where the controller 120 calculates the safety score SCORE_SAFETY However, for convenience of a description, an embodiment where the controller 120 calculates the safety score SCORE_SAFETY based on a voltage will be described.

The controller 120 may be configured to determine the abnormal behavior of battery information.

More specifically, the controller 120 may determine whether the abnormal behavior occurs in the voltage profile of the battery. Herein, the voltage profile may be a profile indicating the voltage distribution of the battery over time. In addition, the abnormal behavior may mean that a voltage of the battery deviates from a normal range at one or more time points.

The controller 120 may be configured to calculate a similarity between the determined abnormal behavior and a preset abnormal profile.

Herein, the abnormal profile may mean a plurality of experiment data obtained through an experiment in advance and may be a profile in which the abnormal behavior occurs in the voltage profile. The controller 120 may calculate similarities between the abnormal behavior determined for the battery and a plurality of abnormal profiles. As an algorithm for measuring a similarity between two profiles (the voltage profile of the battery and the abnormal profile), a conventional similarity determining algorithm may be applied.

The controller 120 may be configured to determine a safety class based on the calculated similarity.

For example, the safety class may be predetermined for each of the plurality of abnormal profiles. Thus, the controller 120 may determine the safety class of the battery based on the similarity between the abnormal behavior of the voltage profile and each of the plurality of abnormal profiles.

For example, in the embodiment of FIG. 7, the safety class of the battery may be classified into the class A, the class B, and the class C.

The controller 120 may be configured to calculate the safety score SCORE_SAFETY corresponding to the safety class based on a preset safety class table.

In the safety class table, the safety class and the safety score SCORE_SAFETY corresponding thereto may be mapped to each other and stored. Thus, the controller 120 may be configured to calculate the safety score SCORE_SAFETY corresponding to the safety class based on the safety class table.

For example, in the embodiment of FIG. 7, the safety score SCORE_SAFETY may be set to 100 points, 95 points, and 90 points respectively for the class A, the class B, and the class C.

Hereinbelow, an embodiment where the controller 120 identifies the abnormal behavior of the battery will be described.

The controller 120 may determine an observation matrix indicating a voltage profile over time.

The controller 120 may extract a first sub matrix, a second sub matrix, and a third sub matrix by applying matrix decomposition to an observation matrix.

Herein, the controller 120 may apply matrix decomposition to the observation matrix by using singular value decomposition (SVD), principal component analysis (PCA), etc.

The observation matrix may be decomposed into the first sub matrix, the second sub matrix, and the third sub matrix by matrix decomposition. The first sub matrix may be an $m \times m$ matrix, the second sub matrix may be an $m \times n$

matrix, and the third sub matrix may be an n × n matrix. Herein, a product of the first sub matrix, the second sub matrix, and the third sub matrix may be the same as the observation matrix. In addition, n may mean the number of batteries, and m may mean the number of measured voltages. That is, the m × n matrix may mean that a voltage is measured m times for each of n batteries.

Matrix decomposition is a widely used scheme, and thus a detailed theoretical description thereof will be omitted.

The first sub matrix, which is an orthogonal matrix, may include a plurality of principal component vectors indicating variance information of the observation matrix. Each of the plurality of principal component vectors may be referred to as a left singular vector. Each principal component may include m elements and may be a column vector of the first sub matrix.

The second sub matrix is a diagonal matrix in which the other elements than n elements in the principal diagonal line may be all 0s.

The third sub matrix is an orthogonal matrix including a plurality of coefficient vectors indicating dependency information for the plurality of principal component vectors. Each of the plurality of coefficient vectors may be referred to as a right singular vector.

The controller 120 may determine a principal component vector including an invalid coefficient among the plurality of principal component vectors included in the third sub matrix. For example, the controller 120 may calculate an average of a plurality of coefficients for each principal component vector. The controller 120 may determine a principal component vector including a coefficient (that is the invalid coefficient) that differs from the calculated average by a preset first reference value or more.

The controller 120 may determine a partial voltage vector corresponding to the determined principal component vector from the observation matrix. Herein, the partial voltage vector may be the m×1 matrix. The controller 120 may determine that the abnormal behavior occurs in the battery corresponding to the partial voltage vector when a difference between the maximum partial voltage and the minimum partial voltage of the partial voltage vector is equal to or greater than a preset second reference value.

Last, the controller 120 may determine similarities between a voltage profile for the battery having the abnormal behavior occurring therein and a plurality of preset abnormal profiles and determine a safety class for the battery according to a result of determination. The controller 120 may calculate the safety score SCORE_SAFETY of the battery based on the determined safety class.

The controller 120 may be configured to determine a battery life score by applying a weight value preset to correspond to each of the SOH score SCORE_SOH, the RUL score SCORE _RUL, and the safety score SCORE_SAFETY and summing an application result.

Herein, the life score may be a score evaluated by the controller 120 by combining the SOH score SCORE_SOH, the RUL score SCORE_RUL, and the safety score SCORE_SAFETY More specifically, the controller 120 may determine the battery life score by using Equation 3 below.

[Equation 3]

$$SCORE\_LIFE = SCORE\_SOH \times a + SCORE\_RUL \times b + SCORE\_SAFETY \times c$$

Herein, SCORE_LIFE may mean the battery life score, SCORE_SOH may mean the SOH score, SCORE_RUL may mean the RUL score, and SCORE_SAFETY may mean the safety score. a indicates a first weight value applied to the SOH score SCORE_SOH, b indicates a second weight value applied to the RUL score SCORE RUL, and c indicates a third weight value applied to the safety score SCORE_SAFETY

For example, a sum of a, b, and c may be equal to 1. That is, a sum of a first score corresponding to a rate a of the SOH score SCORE_SOH, a second score corresponding to a rate b of the RUL score SCORE _RUL, and a third score corresponding to a rate c of the safety score SCORE_SAFETY may be calculated as a battery life score SCORE LIFE.

The battery management apparatus 100 according to an embodiment of the present disclosure may not only provide detailed scores such as the SOH score SCORE_SOH, the RUL score SCORE_RUL, the safety score SCORE_SAFETY, etc., for the battery, but also provide the battery life score SCORE_LIFE, calculated by combining the detailed scores. Thus, users may identify detailed scores for the battery management apparatus 100 and also the battery life score SCORE_LIFE which is a combined score. In particular, when a user fails to accurately recognize what the detailed scores mean, the user may identify the battery life score SCORE_LIFE, thereby intuitively identifying a performance evaluation result for the battery the user uses.

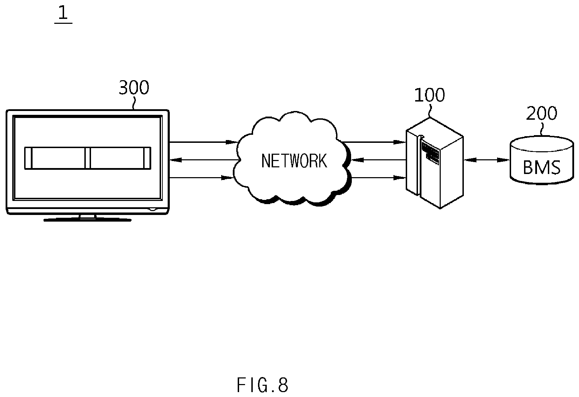

FIG. 8 is a diagram schematically showing an exemplary configuration of a battery system 1 according to another embodiment of the present disclosure.

The battery system 1 according to another embodiment of the present disclosure may include the battery management apparatus 100 according to an embodiment of the present disclosure.

Referring to FIG. 8, the battery system 1 may include the battery management apparatus 100, a battery management system (BMS) 200, and a user terminal 300.

The battery management apparatus 100 and the BMS 200 may be connected to communicate with each other over a wired and/or wireless network. The battery management apparatus 100 and the user terminal 300 may be connected to communicate with each other over a wireless network.

For example, the BMS 200 may be included in an electric vehicle of the user. The BMS 200 may measure battery information such as a voltage, a current, etc., of a battery pack included in the electric vehicle, and transmit the measured battery information to the battery management apparatus 100. More specifically, the BMS 200 may transmit the battery information to the data obtaining unit 110 of the battery management apparatus 100.

The battery management apparatus 100 may store the battery information received from the BMS 200. Upon receiving a request message for the battery life score from the user terminal 300, the battery management apparatus 100 may calculate the battery life score based on the stored battery information and transmit a response message to the calculated battery life score to the user terminal 300.

For example, the battery management apparatus 100 may be included in a server device, such as a cloud server, etc., to which both the BMS 200 and the user terminal 300 are connected.

The battery management apparatus 100 may provide a battery life score for a plurality of users. Statistical information may be provided together with the battery life score for the plurality of users.

The user terminal 300 may transmit the request message for the battery life score to the battery management apparatus 100 and receive the response message to the request message. The battery life score corresponding to the response message may be output through a display unit of the user terminal 300.

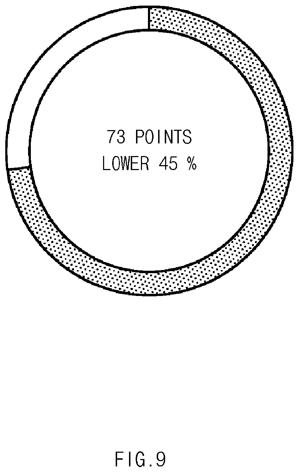

FIG. 9 is a view schematically showing an output example of a life score provided to a user, according to an embodiment of the present disclosure.

For example, in the embodiment of FIG. 9, it is assumed that the life score of the battery is determined to be 73 points. From the user terminal 300, the battery life score SCORE_LIFE may be output. In addition, statistical information indicating that the battery life score SCORE_LIFE of the corresponding user is in a bottom 45 % among battery life scores of a plurality of users.

The user may request a score for a detailed item, such as the SOH score SCORE_SOH, the RUL score SCORE RUL, the safety score SCORE_SAFETY, etc., and request the battery life score SCORE_LIFE which is a combined score. The user may compare the battery life score of the user with the battery life scores of the plurality of users.

In addition, the battery management apparatus 100 may transmit guide information corresponding to each of the battery life score, the SOH score SCORE_SOH, the RUL score SCORE _RUL, and the safety score SCORE_SAFETY to the user terminal 300. That is, the user may be provided with proper guide information for improving the life of the battery from the battery management apparatus 100.

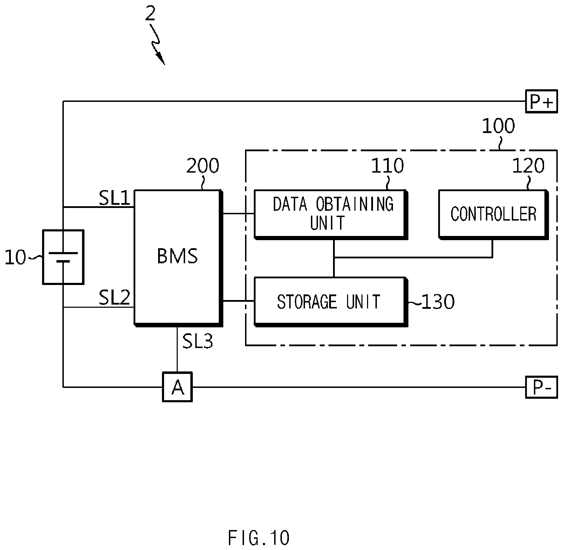

FIG. 10 is a diagram schematically showing an exemplary configuration of a battery pack 2 according to another embodiment of the present disclosure.

The battery pack 2 according to another embodiment of the present disclosure may include the battery management apparatus 100 according to an embodiment of the present disclosure. The battery pack 2 may further include an electrical component (a relay, a fuse, etc.), a case, and so forth.

A positive terminal of the battery 10 may be connected to a positive terminal P+ of the battery pack 2, and a negative terminal of the battery 10 may be connected to a negative terminal P- of the battery pack 2.

The BMS 200 may be connected to a first sensing line SL1, a second sensing line SL2, and a third sensing line SL3. More specifically, the BMS 200 may include a measuring module capable of periodically measuring a voltage and a current of the battery 10.

The BMS 200 may be connected to the positive terminal of the battery 10 through the first sensing line SL1 and to the negative terminal of the battery 10 through the second sensing line SL2. The BMS 200 may measure a voltage of the battery 10 based on a voltage measured in each of the first sensing line SL1 and the second sensing line SL2.

The BMS 200 may be connected to a current measuring unit A through the third sensing line SL3. For example, the current measuring unit A may be an ammeter or a shunt resistor capable of measuring a charge current and a discharge current of the battery 10. The BMS 200 may measure a charge current of the battery 10 through the third sensing line SL3 to calculate the amount of charge. The BMS 200 may also measure the discharge current of the battery 10 through the third sensing line SL3 to calculate the amount of discharge.

Although not shown in FIG. 10, the BMS 200 may be configured to further measure a temperature of the battery 10.

The BMS 200 may transmit the measured battery information to the battery management apparatus 100. More specifically, the BMS 200 may transmit the measured battery information to the data obtaining unit 110 of the battery management apparatus 100.

While the battery management apparatus 100 and the BMS 200 have been described as separate components, the battery management apparatus 100 may be included as a component of the BMS 200 depending on an embodiment. That is, the battery management apparatus 100 according to the present disclosure may be applied to the BMS 200. That is, the BMS 200 according to the present disclosure may include the above-described battery management apparatus 100. With this configuration, at least some of components of the battery management apparatus 100 may be implemented by supplementing or adding functions of components included in the BMS 200. For example, the data obtaining unit 110, the controller 130, and the storage unit 130 of the battery management apparatus 100 may be implemented as components of the BMS 200.

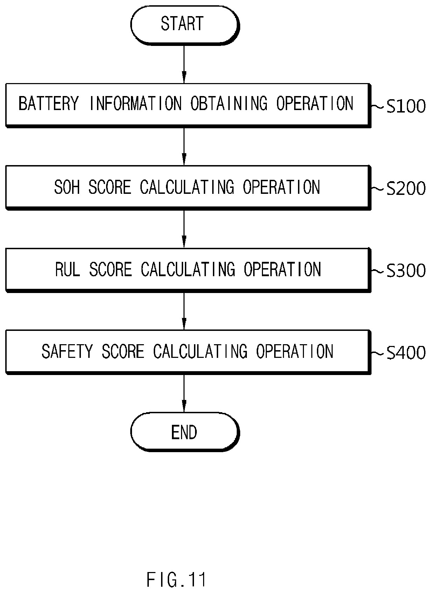

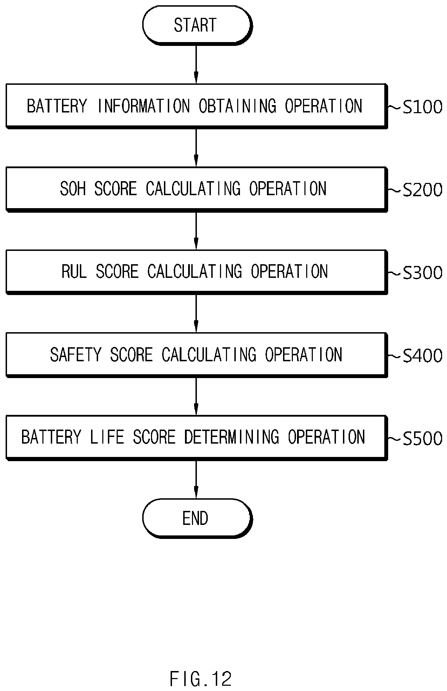

FIGS. 11 and 12 are diagrams schematically showing a battery management method according to another embodiment of the present disclosure.

Preferably, each operation of the battery management method may be performed by the battery management apparatus 100. Hereinbelow, a matter redundant to the foregoing matter described will be omitted or briefly described.

Referring to FIG. 11, a battery management method may include battery information obtaining operation S100, SOH score calculating operation S200, RUL score calculating operation S300, and safety score calculating operation S400.

Although an embodiment is shown in FIG. 11 in which the SOH score calculating operation S200, the RUL score calculating operation S300, and the safety score calculating operation S400 are sequentially performed, the SOH score calculating operation S200, the RUL score calculating operation S300, and the safety score calculating operation S400 are independent operations. Thus, it should be noted that an execution order of the SOH score calculating operation S200, the RUL score calculating operation S300, and the safety score calculating operation S400 is not limited by the embodiment of FIG. 11.

The battery information obtaining operation S100 may be an operation of obtaining battery information including at least one of voltage and current of a battery, and may be performed by the data obtaining unit 110.

The SOH score calculating operation S200 is an operation of estimating a SOH of a battery based on battery information and calculating a SOH score SCORE_SOH for the battery based on a reference value corresponding to a SOH and the SOH in a plurality of reference profiles, and may be performed by the controller 120.

The controller 120 may estimate the SOH of the battery SOH_P based on the battery information. The controller 120 may determine the first reference value SOH_R1 in the first reference profile RP1, and the second reference value SOH_R2 in the second reference profile RP2, based on the estimated SOH SOH_P. Last, the controller 120 may calculate the SOH score SCORE_SOH by scoring a rate with respect to the estimated SOH SOH_P in the SOH reference section SOH_R corresponding to the first reference value SOH_R1 and the second reference value SOH_R2.

The RUL score calculating operation S300 is an operation of predicting a plurality of SOH of the battery in the target period TR and calculating the RUL score SCORE_RUL for the battery based on a plurality of reference values corresponding to the plurality of SOH and the plurality of SOH in a plurality of reference profiles, and may be performed by the controller 120.

The controller 120 may select the plurality of SOH SOH_P in the SOH profile P during the target period TR. The controller 120 may also determine the plurality of first reference values SOH_R1 in the first reference profile RP1 and the plurality of second reference values SOH_R2 in the second reference profile RP2, based on the plurality of selected SOH SOH_P. Last, the controller 120 may calculate the RUL score SCORE_RUL by scoring a rate with respect to a sum of the plurality of SOH in an RUL reference section RUL_R corresponding to the plurality of first reference values SOH_R1 and the plurality of second reference values SOH_R2.

The safety score calculating operation S400 may be an operation of calculating the safety score SCORE_SAFETY of the battery according to a safety class of the battery based on the battery information.

The controller 120 may determine the safety class of the battery based on a similarity between the battery information and a plurality of preset abnormality data. Thus, the controller 120 may calculate the safety score SCORE_SAFETY corresponding to the determined safety class based on the safety class table.

The battery management method may have the advantage of evaluating the performance of the battery in various aspects by calculating the SOH score SCORE_SOH, the RUL score SCORE _RUL, and the safety score SCORE_SAFETY based on the battery information.

Referring to FIG. 12, the battery management method may further include battery life score determining operation S500.

The battery life score determining operation S500 may be an operation of determining a battery life score by applying a weight value preset to correspond to each of the SOH score SCORE_SOH, the RUL score SCORE RUL, and the safety score SCORE_SAFETY and summing an application result, and may be performed by the controller 120.

The controller 120 may apply the first weight value to the SOH score SCORE_SOH, the second weight value to the RUL score SCORE _RUL, and the third weight value to the safety score SCORE_SAFETY The controller 120 may determine the battery life score SCORE_LIFE by summing the weight value-applied SOH score SCORE_SOH, RUL score SCORE_RUL, and safety score SCORE_SAFETY.

The battery management method may not only calculate a score for a detailed item, such as the SOH score SCORE_SOH, the RUL score SCORE_RUL, the safety score SCORE_SAFETY, etc., but also determine the battery life score SCORE_LIFE which is a combined score. Thus, the user may objectively check the current state of the battery by checking the battery life score SCORE_LIFE, which is a comprehensive indicator.

The embodiments of the present disclosure described above are not implemented only through apparatuses and methods, and may be implemented through a program that realizes functions corresponding to the configuration of the embodiments of the present disclosure or a recording medium on which the program is recorded, and such implementation may be easily achieved from the description of the above-described embodiments by an expert in the technical field to which the present disclosure pertains.

Although the present disclosure has been described above with limited embodiments and drawings, the present disclosure is not limited thereto and various modifications and changes may be made by those of ordinary skill in the art within a range equivalent to the technical spirit of the present invention and the claims described below.

Moreover, various substitutions, modifications, and changes may be made by those of ordinary skill in the art to the above-described invention without departing the technical spirit of the present invention, and thus the present invention is not limited by the above-described embodiments and the attached drawings, but all or some of the embodiments may be selectively combined to make various modifications.

**Claims**

1. A battery management apparatus, comprising:

   a data obtaining unit configured to obtain battery information comprising at least one of voltage and current of a battery; and
   a controller configured to:

   estimate a state of health (SOH) of the battery based on the battery information,
   calculate a SOHSOH score for the battery based on a reference value corresponding to the SOH and the SOH in a plurality of reference profiles,
   predict a plurality of SOH of the battery during a target period,
   calculate a remaining useful life (RUL) score for the battery based on the plurality of SOH, and
   determine a safety score of the battery according to a safety class of the battery based on the battery information.

2. The battery management apparatus of claim 1, wherein the plurality of reference profiles comprise a first reference profile indicating a maximum SOH per unit time for the battery and a second reference profile indicating a minimum SOH per unit time for the battery.

3. The battery management apparatus of claim 2, wherein the controller is further configured to:

   determine a first reference value corresponding to the SOH in the first reference profile,
   determine a second reference value corresponding to the SOH in the second reference profile, and
   calculate the SOH score based on a rate of the SOH with respect to the first reference value and the second reference value.

4. The battery management apparatus of claim 3, wherein the controller is further configured to:

   determine a SOH reference section for the first reference value and the second reference value,
   calculate a rate of the SOH with respect to the SOH reference section, and
   score the calculated rate of the SOH to calculate the SOH score.

5. The battery management apparatus of claim 2, wherein the controller is further configured to:

   determine a plurality of first reference values during the target period in the first reference profile,
   determine a plurality of second reference values during the target period in the second reference profile, and
   calculate an RUL score based on a rate of the plurality of SOH with respect to the plurality of first reference values and the plurality of second reference values.

6. The battery management apparatus of claim 5, wherein the controller is further configured to:

   determine an RUL reference section for a sum of the plurality of first reference values and a sum of the plurality of second reference values,
calculate a rate of a sum of the plurality of SOH with respect to the RUL reference section, and
score the calculated rate of the sum to calculate the RUL score.

**7.**

The battery management apparatus of claim 2, wherein the plurality of reference profiles comprise a third reference profile indicating an average SOH per unit time for the battery, and
wherein the controller is further configured to:

determine a target time point corresponding to a preset threshold value in the third reference profile, and
set a period from a current time point at which the SOH is estimated to the target time point as the target period.

**8.** The battery management apparatus of claim 1, wherein the target period is set from the current time point at which the SOH is estimated to an expiration time point of a warranty period preset for the battery.

**9.** The battery management apparatus of claim 1, wherein the controller is further configured to calculate the safety score corresponding to the safety class based on a preset safety class table.

**10.** The battery management apparatus of claim 9, wherein the controller is further configured to:

determine an abnormal behavior of the battery information,
calculate a similarity between the determined abnormal behavior and a preset abnormal profile, and
determine the safety class based on the calculated similarity.

**11.** The battery management apparatus of claim 1, wherein the controller is further configured to determine a battery life score by applying a weight value preset to correspond to each of the SOH score, the RUL score, and the safety score and summing an application result.

**12.** A battery system comprising the battery management apparatus according to any one of claims 1 to 11.

**13.** A battery pack comprising the battery management apparatus according to any one of claims 1 to 11.

**14.** A battery management method comprising:

a battery information obtaining operation of obtaining battery information comprising at least one of voltage and current of a battery;
a state of health (SOH) score calculating operation of estimating a SOH of the battery based on the battery information and calculating a SOH score for the battery based on a reference value corresponding to the SOH and the SOH in a plurality of reference profiles;
a remaining useful life (RUL) score calculating operation of predicting a plurality of SOH of the battery during a target period and calculating an RUL score for the battery based on the plurality of SOH; and
a safety score calculating operation of calculating a safety score of the battery according to a safety class of the battery based on the battery information.

100

BATTERY MANAGEMENT APPARATUS

DATA OBTAINING UNIT ~110

CONTROLLER ~120

STORAGE UNIT ~130

FIG.1

FIG.2

| TIME POINT / ITEM | TC |
|---|---|
| SOH_R1[%] | 96 |
| SOH_R2[%] | 78 |
| SOH_P[%] | 88 |
| SOH_R[%] | 18 |
| SCORE_SOH | 55.6 |

FIG.3

FIG.4

| TIME POINT / ITEM | TC | TF1 | TF2 | TF3 | TT |
|---|---|---|---|---|---|
| SOH_R1[%] | 96 | 94 | 92 | 90 | 88 |
| SOH_R2[%] | 78 | 76 | 74 | 72 | 70 |
| SOH_P[%] | 88 | 87 | 86 | 85 | 84 |
| RUL_R[%] | 90 | | | | |
| SCORE_RUL | 66.7 | | | | |

FIG.5

FIG.6

| SAFETY CLASS | SCORE_SAFETY |
|:---:|:---:|
| A | 100 |
| B | 95 |
| C | 90 |

FIG.7

1

FIG.8

73 POINTS
LOWER 45 %

FIG.9

2

P+

100

200

110

120

SL1

10

BMS

DATA OBTAINING
UNIT

CONTROLLER

SL2

STORAGE UNIT

~130

SL3

A

P-

FIG.10

START

BATTERY INFORMATION OBTAINING OPERATION ~S100

SOH SCORE CALCULATING OPERATION ~S200

RUL SCORE CALCULATING OPERATION ~S300

SAFETY SCORE CALCULATING OPERATION ~S400

END

FIG.11

START

BATTERY INFORMATION OBTAINING OPERATION ～S100

SOH SCORE CALCULATING OPERATION ～S200

RUL SCORE CALCULATING OPERATION ～S300

SAFETY SCORE CALCULATING OPERATION ～S400

BATTERY LIFE SCORE DETERMINING OPERATION ～S500

END

FIG.12

<table>
<tr><td colspan="2"><b>INTERNATIONAL SEARCH REPORT</b></td><td>International application No.<br><b>PCT/KR2022/018849</b></td></tr>
</table>

**A.    CLASSIFICATION OF SUBJECT MATTER**

**G01R 31/367**(2019.01)i; **G01R 31/392**(2019.01)i; **G01R 31/382**(2019.01)i

According to International Patent Classification (IPC) or to both national classification and IPC

**B.    FIELDS SEARCHED**

Minimum documentation searched (classification system followed by classification symbols)

G01R 31/367(2019.01); G01R 19/165(2006.01); G01R 31/36(2006.01); G01R 31/382(2019.01); H01M 10/42(2006.01); H01M 10/48(2006.01); H01M 10/54(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: SOH(state of health), RUL(remaining useful life), 잔존(remaining), 전압(voltage), 전류(current), 참조(reference), 프로파일(profile), 점수(score), 타겟 기간(target period), 등급(grade)

**C.    DOCUMENTS CONSIDERED TO BE RELEVANT**

| Category* | Citation of document, with indication, where appropriate, of the relevant passages | Relevant to claim No. |
|---|---|---|
| A | KR 10-2201988 B1 (NASAN ELECTRIC INDUSTRIES CO., LTD.) 12 January 2021 (2021-01-12)<br>        See paragraph [0012] and claim 1. | 1-14 |
| A | KR 10-2022-0027791 A (LG ENERGY SOLUTION, LTD.) 08 March 2022 (2022-03-08)<br>        See claim 1. | 1-14 |
| A | KR 10-2016-0107093 A (SAMSUNG ELECTRONICS CO., LTD.) 13 September 2016 (2016-09-13)<br>        See claim 1 and figure 2. | 1-14 |
| A | JP 2022-514992 A (MITSUBISHI ELECTRIC CORP.) 16 February 2022 (2022-02-16)<br>        See claim 1 and figure 8. | 1-14 |
| A | JP 6722954 B1 (TOYO SYSTEM CO., LTD.) 15 July 2020 (2020-07-15)<br>        See claim 1. | 1-14 |

☐ Further documents are listed in the continuation of Box C.    ☑ See patent family annex.

| | |
|---|---|
| *    Special categories of cited documents:<br>"A"  document defining the general state of the art which is not considered to be of particular relevance<br>"D"  document cited by the applicant in the international application<br>"E"  earlier application or patent but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family |

| Date of the actual completion of the international search | Date of mailing of the international search report |
|---|---|
| **03 March 2023** | **03 March 2023** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
Information on patent family members

International application No.

**PCT/KR2022/018849**

| Patent document cited in search report | | | Publication date (day/month/year) | Patent family member(s) | | | Publication date (day/month/year) |
|---|---|---|---|---|---|---|---|
| KR | 10-2201988 | B1 | 12 January 2021 | | None | | |
| KR | 10-2022-0027791 | A | 08 March 2022 | CN | 115151922 | A | 04 October 2022 |
| | | | | WO | 2022-045842 | A1 | 03 March 2022 |
| KR | 10-2016-0107093 | A | 13 September 2016 | US | 10345391 | B2 | 09 July 2019 |
| | | | | US | 2016-0259013 | A1 | 08 September 2016 |
| JP | 2022-514992 | A | 16 February 2022 | JP | 7199568 | B2 | 05 January 2023 |
| | | | | US | 10921383 | B2 | 16 February 2021 |
| | | | | US | 2020-0284846 | A1 | 10 September 2020 |
| | | | | WO | 2020-179120 | A1 | 10 September 2020 |
| JP | 6722954 | B1 | 15 July 2020 | CA | 3133950 | A1 | 08 October 2020 |
| | | | | CN | 113646949 | A | 12 November 2021 |
| | | | | EP | 3913727 | A1 | 24 November 2021 |
| | | | | JP | 2020-170622 | A | 15 October 2020 |
| | | | | KR | 10-2021-0127735 | A | 22 October 2021 |
| | | | | TW | 202040154 | A | 01 November 2020 |
| | | | | TW | I745855 | B | 11 November 2021 |
| | | | | US | 2022-0163597 | A1 | 26 May 2022 |
| | | | | WO | 2020-202752 | A1 | 08 October 2020 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020220034948